Europäisches Patentamt

European Patent Office

Office européen des brevets

(11) Numéro de publication: **0 208 579**
**A1**

## (12) DEMANDE DE BREVET EUROPEEN

(21) Numéro de dépôt: 86401263.8

(51) Int. Cl.4: **G01N 24/04**

(22) Date de dépôt: 10.06.86

(30) Priorité: 11.06.85 FR 8508810

(43) Date de publication de la demande:
14.01.87 Bulletin 87/03

(84) Etats contractants désignés:
DE GB NL

(71) Demandeur: THOMSON-CGR
13, square Max-Hymans
F-75015 Paris(FR)

(72) Inventeur: Prevot, Claude
THOMSON-CSF SCPI 19, avenue de Messine
F-75008 Paris(FR)
Inventeur: Encellaz, Robert-Maxime
THOMSON-CSF SCPI 19, avenue de Messine
F-75008 Paris(FR)
Inventeur: Sireul, Jacques
THOMSON-CSF SCPI 19, avenue de Messine
F-75008 Paris(FR)

(74) Mandataire: Grynwald, Albert et al
THOMSON-CSF SCPI 19, avenue de Messine
F-75008 Paris(FR)

(54) **Procédé de fabrication d'un écran et écran notamment pour appareil d'imagerie pour résonance magnétique nucléaire.**

(57) L'invention a pour objet un procédé de fabrication d'un écran dans lequel, pour résoudre des problèmes de voilages différentiels entre des couches (2,3) métalliques surperposées et formées cylindriquement, on utilise une feuille (1) isolante métallisée double face comme on en trouve dans le domaine de la fabrication des circuits imprimés. Quels que soient les pliures et les voilages auxquels cette feuille est ultérieurement soumise avant d'être appliquée (14-16) contre une enveloppe (13) solide de maintien, l'épaisseur (e) de la feuille entre métallisation reste suffisamment constante pour que la valeur caractéristique de la capacité ainsi constituée soit invariante. De cette manière on réalise un filtre fréquentiel pour empêcher une induction haute fréquence de traverser l'écran. Par contre cet écran autorise le passage d'une induction magnétique basse fréquence.

Application à l'imagerie par résonance magnétique nucléaire.

Fig.1

## PROCEDE DE FABRICATION D'UN ECRAN ET ECRAN, NOTAMMENT POUR APPAREIL D'IMAGERIE PAR RESONANCE MAGNETIQUE NUCLEAIRE.

La présente invention a pour objet un procédé de fabrication d'un écran. Elle concerne également un écran tel qu'on en utilise dans des appareils d'imagerie par résonance magnétique nucléaire.

Un appareil d'imagerie par résonance nucléaire comporte des moyens pour soumettre un corps à examiner à un champ magnétique continu intense. Il comporte en outre des moyens pour soumettre ce corps à des gradients de champ magnétique continu. Il comporte enfin des moyens d'"excitation magnétique haute fréquence pour faire basculer l'orientation des moments magnétiques des noyaux du corps. Après la phase d'excitation les moments magnétiques des noyaux se réorientent dans le sens du champ magnétique continu intense en émettant une onde de désexcitation que l'on détecte et qui sert pour la représentation d'images de coupes du corps à examiner.

En général la conformation des appareils est cylindrique circulaire. Les moyens pour soumettre le corps à l'excitation magnétique haute fréquence sont disposés coaxialement à l'intérieur des moyens pour soumettre le corps à des gradients de champ magnétique continu. Les moyens de gradients sont eux-mêmes disposés coaxialement aux moyens de production du champ magnétique continu intense. L'écran dont il est question dans la présente invention est un écran cylindrique qui vient s'interposer entre ces deux premiers moyens : d'excitation et de gradients. Son but est de laisser passer les gradients de champ magnétique continu pour qu'ils viennent porter leur induction dans le corps à examiner. Cet écran doit par contre empêcher l'excitation magnétique haute fréquence de le traverser et de venir perturber le fonctionnement des moyens de production des gradients de champ magnétique continu.

En fait les gradients de champ magnétique continu ne sont pas produits en permanence. Ils ne sont appliqués que périodiquement. La durée du temps de leur montée, ou de leur établissement, est d'ailleurs une caractéristique des images ultérieures à réaliser. Il semble qu'un bon compromis en imagerie médicale se situe pour ces temps de montée autour d'une milliseconde. Le spectre en fréquence du signal correspondant est donc compris entre zéro et un kilohertz environ. Or la fréquence des champs magnétiques alternatifs d'excitation est de l'ordre du mégahertz. Pour résoudre le problème d'influence mutuelle, il a été imaginé de réaliser les écrans sous la forme de filtre fréquentiel passe-bas. Les gradients de champ dont le spectre en fréquence est peu élevé peuvent traverser le filtre ; le champ magnétique haute fréquence y est arrêté. Un tel écran a l'allure de deux plaques métalliques en vis-à-vis formant capacités. La valeur de la capacité fixe la fréquence de coupure du filtre.

Le problème de la fabrication d'un écran réside dans sa forme cylindrique et dans le fait que ses dimensions sont importantes. Dans un exemple le diamètre d'une section circulaire d'un écran cylindrique vaut environ 75 centimètres, la circonférence valant 2,40 mètres. Sa longueur vaut environ 1 mètre. Pour réaliser l'écran on prend deux plaques métalliques et on les appose de part et d'autre d'une enveloppe cylindrique en un matériau diélectrique. On se heurte dès cet instant à deux difficultés. Premièrement, pour que la capacité ainsi produite soit suffisamment forte, il faut réduire l'épaisseur de l'enveloppe. La limite de cette réduction est fixée par la solidité mécanique de l'enveloppe utilisée. Deuxièmement, il est quasiment impossible de former trois plaques dans les dimensions indiquées de telle manière qu'elles viennent s'appliquer parfaitement, en tous endroits, les unes contre les autres. Dans tous les cas, du fait des contraintes mécaniques internes aux plaques métalliques et à l'enveloppe, il y a beaucoup de régions où l'espacement entre les deux plaques métalliques ne respecte pas les cotes imposées. Il en résulte une variation de la valeur de la capacité en fonction des régions de l'écran. En agissant ainsi on construit un filtre fréquentiel dont la fréquence de coupure n'est pas la même en tous points de l'écran. Son fonctionnement est dégradé. En particulier les régions où les gauchissements des plaques ont eu pour effet de les écarter l'une de l'autre se comportent à l'égard de l'excitation magnétique haute fréquence comme des trous : elles la laissent passer en direction des moyens de production des gradients de champ magnétique continu.

La présente invention propose de remédier aux inconvénients cités en présentant un écran dans lequel en tous endroits les surfaces métalliques formant capacité sont maintenues entre elles avec un écart constant quelles que soient les déformations de l'enveloppe. Cet écart constant est d'ailleurs égal à l'épaisseur de l'enveloppe.

La présente invention a pour objet un procédé de fabrication d'un écran, notamment pour appareil d'imagerie par résonance magnétique nucléaire, caractérisé en ce qu'il comporte les étapes·suivantes :

-on métallise les deux faces d'une feuille plane et souple en un matériau diélectrique à faible perte,

-on réalise, sur chaque face, une partition de la surface métallisée par enlèvement de rubans de métal, tous les rubans étant orientés sensiblement parallèlement les uns aux autres et les rubans enlevés sur une face étant décalés de l'aplomb des rubans enlevés sur l'autre face,

-on applique la feuille ainsi transformée contre une enveloppe cylindrique de manière à ce qu'elle couvre sensiblement exactement cette enveloppe, les bords de la feuille venant s'abouter chant contre chant,

-et on relie galvaniquement les parties aboutées des surfaces métallisées correspondantes d'au moins une face.

L'invention à également pour objet un écran notamment pour appareil d'imagerie par résonance magnétique nucléaire, caractérisé en ce qu'il comporte une feuille en un matériau diélectrique à faible perte et métallisée sur ses deux faces, les surfaces métallisées de chaque face étant divisées en des bandes métallisées disjointes et parallèles, chaque bande d'une face se trouvant à l'aplomb d'une séparation de bandes de l'autre face, la feuille étant appliquée contre une enveloppe cylindrique et ses bords parallèles aux bandes étant aboutés chant contre chant, et des surfaces métallisées bordant ces abouts sur au moins une face étant reliées galvaniquement entre elles le long de l'aboutement des bords.

L'invention sera mieux comprise à la lecture de la description qui suit et à l'examen des figures qui l'accompagent. Sur celles-ci les mêmes repères désignent les mêmes éléments. Elles ne sont données qu'à titre indicatif et nullement limitatif de l'invention. Elles représentent :

-figure 1, un écran conforme à l'invention,

-figure 2, une représentation d'une phase du procédé de l'invention.

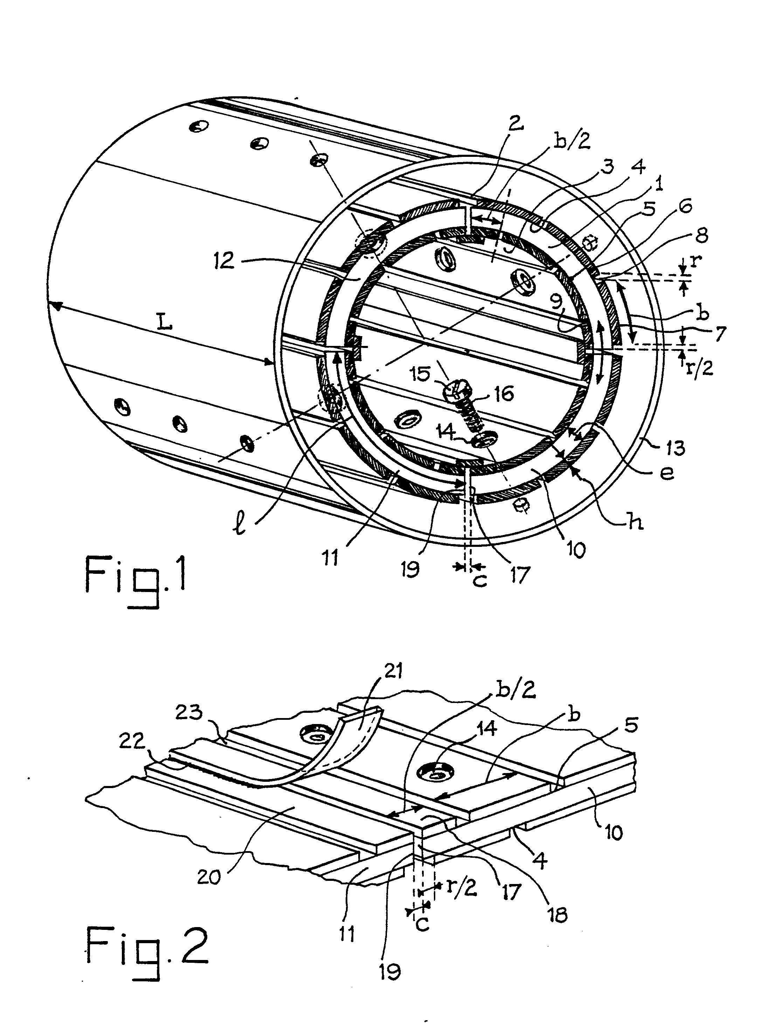

La figure 1 représente un écran conforme à l'invention. Il est de forme générale cylindrique. Il est destiné, par exemple, à être introduit entre des moyens extérieurs (non représentés) de production de gradients de champ magnétique continu, et des moyens intérieurs (également non représentés) de production d'un champ alternatif haute fréquence d'excitation d'un appareil d'imagerie par résonance magnétique nucléaire. La haute fréquence est produite à l'intérieur du cylindre, la basse fréquence est produite à l'extérieur du cylindre. L'induction basse-fréquence doit pouvoir pénétrer à l'intérieur de l'écran, l'excitation haute fréquence ne doit pas pouvoir traverser l'écran. L'écran comporte une feuille 1 en un matériau diélectrique à faible perte. Dans un exemple ce matériau est un polyimide. Il peut être aussi en polyéthylène et plus particulièrement en polytétrafluoroéthylène. La feuille 1 est métallisée sur ses deux faces. Cette métallisation peut être faite par collage de fines feuilles de cuivre sur la feuille diélectrique - (laminage-collage) ou par déposition chimique comme il est connu de le faire pour la fabrication des circuits imprimés souples. Dans un exemple le métal utilisé est du cuivre. La caractéristique des feuilles, vierges à l'origine, utilisées dans l'invention est la régularité de leur épaisseur $e$. Cette constance de l'épaisseur confère la régularité de la valeur de la capacité.

Les surfaces métallisées de chaque face sont divisées en des bandes métallisées, telles que 2 et 3 respectivement sur les faces 4 et 5 de la feuille 1. Les bandes métallisées 6 et 7 d'une face sont disjointes. Elles sont séparées par une rainure 8, de largeur $r$. Toutes les bandes métallisées de la feuille sont parallèles entre elles, même d'une face à l'autre. Par un traitement quelconque, en particulier par une photogravure chimique, on peut réaliser sur chaque face d'une feuille les bandes métallisées en question : on enlève des rubans de métallisation à l'endroit des rainures. On obtient alors le résultat attendu que les bandes métallisées forment d'une face à l'autre les armatures d'une capacité. La valeur surfacique de cette capacité est constante dans toute la feuille du fait de la régularité de l'épaisseur de celle-ci. On obtient donc l'effet attendu qu'un écran réalisé de cette manière ne comporte pas de "trous" pour laisser passer l'excitation haute fréquence. Cette excitation haute fréquence parasite est entièrement absorbée par l'écran. Par contre les gradients de champ magnétique continu pénêtrent à l'intérieur de l'écran en passant au travers des métallisations et au travers de l'épaisseur $e$ de la feuille 1. Du fait de leurs composantes spectrales basse-fréquence, ils ne s'amortissent pas dans l'écran.

Dans un exemple, la feuille métallisée double face utilisée est une feuille de "Kapton" de la société Dupont de Nemours USA ; la feuille 1 est en polyimide, les métallisations appliquées sur les deux faces sont en cuivre. Dans un exemple l'épaisseur $e$ de la feuille 1 vaut 75 micromètres, l'épaisseur $h$ des métallisations de chaque face vaut 35 micromètres. Ces feuilles métallisées double face sont livrées en rouleau de largeur 0,60 mètre. Cette largeur ne correspond pas à la hauteur L souhaitée pour l'écran dans l'application envisagée. Aussi, pour permettre la réalisation de l'écran, on a choisit de le fragmenter en quatre parties de longueur 1 m et de largeur 0,60 m que l'on aboute ultérieurement les unes aux autres. Cette fragmentation facilite par ailleurs le traitement chimique de rainurage des métallisations. Sur la figure 1, les quatre fragments sont cotés 1, 10, 11 et 12. Le périmètre de l'écran vaut alors 2,40 m. Dans un exemple, les rainures 8 sont séparées les unes des autres d'une distance $\underline{b}$ valant environ 20 cm.

L'orientation des rainures est parallèle à l'axe de la forme cylindrique que doit recevoir ultérieurement la feuille. Les raisons en sont les suivantes : les composantes du champ magnétique continu intense et des gradients de champ magnétique continu qui doivent traverser l'écran sont justement orientées dans le sens de cet axe. Ces rainures ont pour but d'éliminer, dans les métallisations recouvrant les deux faces de la feuille 1, les pertes par apparition de courants de Foucault. Ainsi les rainures 8 sont parallèles à ces composantes et sont donc orthogonales aux courants de Foucault que ces champs pourraient induire dans les métallisations. D'une manière préférée les rainures pratiquées sur une face se trouvent en dehors de l'aplomb des rainures pratiquées sur l'autre face. Ceci impose à l'excitation parasite haute fréquence de trouver une capacité en tous endroits sur son chemin d'évasion.

Une fois que la feuille, ou les fragments de feuille, ont été apprêtés avec les rainures, on les applique sur une enveloppe 13 en un matériau ni conducteur, ni magnétique. L'enveloppe 13 peut par exemple être réalisée en résine exopy. L'enveloppe va maintenant servir de maintien à l'écran. L'application de la feuille 1, et éventuellement des fragments 10, 11 et 12, peut être excécutée par tous moyens. Notamment elle peut être collée. Dans une réalisation, elle est appliquée par vissage. A cet effet on pratique dans les métallisations des surfaces, à l'endroit où les vis vont traverser, des réservations telles que 14 pour éviter que les têtes 15 des vis 16 ne puissent provoquer de court-circuits entre les différentes faces de la feuille 1. La somme des longueurs $\underline{l}$ des fragments de feuilles, ou la longueur de la feuille elle-même, sont telles qu'elles sont égales à la circonférence intérieure (ou extérieure) de l'enveloppe 13 contre laquelle elles viennent s'appliquer. L'espace qui apparaît sur le dessin de la figure 1 ne sert qu'à aérer le dessin.

Une feuille ou des fragments de feuille possèdent des bords. Comme l'écran a un contour fermé il est nécessaire d'abouter entre eux les bords de la feuille, ou d'abouter bout à bout les bords des différents fragments. La figure 2 représente la technique utilisée pour effectuer cette opération d'aboutement. Au préalable, on réalise sur les deux faces de la feuille et dans le voisinage des bords, des rainurages différents. Sur une face, la face 4 destinée à être appliquée contre l'enveloppe 13, on pratique en bord de feuille une demi-rainure : de largeur r/2. Sur l'autre face, la face 5, le bord 17 de la feuille est recouvert d'une demi-bande métallisée 18, de largeur b/2 moitié de la largeur $\underline{b}$ d'une bande quelconque. Après ce demi-rainurage on étame, en tout ou partie, la partie apparente de la demi-bande de métallisation 18. Lors du montage la feuille 1, ou le fragment de feuille 10, vient à être appliqué chant contre chant contre l'autre bord de la feuille 1 (ou contre un bord correspondant d'un fragment 11 suivant). Le bord 19 de celle-ci est préparé de la même manière. Au moment de l'application, les métallisations adjacentes proches de ces deux bords et qui sont appliquées contre l'enveloppe 13 sont séparées par un espace double du précédent, soit 2r/2 = r, c'est-à-dire identique à la largeur des rainures qui séparent les autres bandes de métallisation de la feuille. Par contre, sur la face opposée à cette face au contact de l'enveloppe 13, les demi-bandes respectivement 18 et 20 qui sont situées à l'aplomb de ces demi-rainures viennent s'appliquer l'une contre l'autre. Pour assurer que le contact électrique entre ces demi-bandes soit bon on vient souder un feuillard 21 de part et d'autre. Les soudures 22 et 23 des bords de ce feuillard sont d'autant plus aisées que les surfaces correspondantes des bandes ont été préalablement étamées pour bien les recevoir.

On pourrait envisager de réaliser la forme cylindrique de la feuille entièrement avant de l'appliquer contre l'enveloppe 13. Dans les épaisseurs choisies la résistance mécanique de la feuille est suffisante pour en assurer la tenue. De même on aurait pu imaginer de prévoir l'aboutement des bords des fragments en dehors d'une zone réservée sur une face à une rainure. Dans ce cas il aurait fallu effectuer quatre soudures pour appliquer deux feuillards. De ce point de vue la solution préconisée et décrite sur la figure 2 est à la fois plus simple et plus économique. Dans le montage décrit seule l'enveloppe 13 est relativement rigide. La feuille 1 munie de ses deux métallisations est elle plutôt souple. Les plis qui peuvent survenir lors de son application contre l'enveloppe 13 sont sans inconvénients du fait que, même dans ces plis, les cotes des épaisseurs séparant les métallisations sont conservées.

La largeur $\underline{b}$ des bandes métallisées est imposée par les tolérances de pertes par courant de Foucault des gradients de champ dans ces bandes. Cette largeur $\underline{b}$ intervient directement proportionnellement comme coefficient d'amortissement de ces gradients. On est donc tenté de la réduire. Mais du fait d'une part, de la division des surfaces de la feuille 1 et de la largeur nécessaire pour les rainures $\underline{r}$ et, d'autre part, de la technique d'application décrite (figure 2), il est nécessaire que la longueur $\underline{l}$ des fragments de feuille contienne un nombre entier de bandes de largeur $\underline{b}$. Ou, ce qui revient au même, il faut un nombre entier de bande sur le pourtour du cylindre. Dans l'exemple décrit chaque fragment de feuille comporte sur une face trois bandes, et sur l'autre face deux bandes et deux demi-bandes. Pour une même longueur de fragment de feuille on pourrait augmenter le nombre des bandes, et donc réduire en conséquence leur largeur $b$, pour le porter par exemple à cinq unités. Cependant la capacité présentée entre deux bandes métallisées disposées sur des faces opposées de la feuille se réduit quand la largeur de ces bandes se réduit. La fréquence de coupure du filtre en est modifiée en conséquence. Pour revenir à une fréquence de coupure convenable il est alors nécessaire de réduire l'épaisseur $e$ de la feuille 1. Dans l'exemple avec cinq bandes métallisées réalisées sur un fragment de feuille de 60 cm de large, il faut une épaisseur d'environ 50 micromètres. Au delà de cette valeur la réduction d'épaisseur ne semble pas possible du fait du défaut de résistance mécanique de la feuille qu'il en résulte.

## Revendications

1. Procédé de fabrication d'un écran, notamment pour appareil d'imagerie par résonance magnétique nucléaire, caractérisé en ce qu'il comporte les étapes suivantes :

-on métallise (2,3) les deux faces (4,5) d'une feuille (1) plane et souple en un matériau diélectrique à faible perte,

-on réalise, sur chaque face, une partition (6,7) de la surface métallisée par enlèvement de rubans (8) de métal, tous les rubans étant orientés sensiblement parallèlement les uns aux autres, et les rubans enlevés sur une face étant décalés de l'aplomb des rubans enlevés sur l'autre face,

-on applique (14-16) la feuille ainsi transformée contre une enveloppe (13) cylindrique de manière à ce qu'elle couvre sensiblement exactement cette enveloppe, les bords (17,19) de la feuille venant s'abouter chant contre chant,

-et on relie (18, 20-23) galvaniquement les parties aboutées des surfaces métallisées correspondantes d'au moins une face.

2. Procédé selon la revendication 1, caractérisé en ce que la partition des surfaces est faite par gravure chimique.

3. Procédé selon l'une quelconque des revendications 1 ou 2, caractérisé en ce que l'application est faite par collage.

4. Procédé selon l'une quelconque des revendications 1 ou 2, caractérisé en ce que l'application est exécutée par vissage (14-16), en dégageant -(44) sur les faces de la feuille les métallisations correspondant au appuis 15 des vis.

5. Procédé selon l'une quelconque des revendications 1 à 4, caractérisé en ce que pour relier galvaniquement on étame les parties (18,20) à abouter des surfaces métalliques correspondantes, et en ce qu'on soude de part et d'autre sur ces parties les bords d'un feuillard (21) métallique allongé.

6. Procédé selon l'une quelconque des revendications 1 à 5, caractérisé en ce que la face (5) de la feuille dont les surfaces sont reliées galvaniquement est la face de la feuille opposée à la face (4) appliquée contre l'enveloppe.

7. Procédé selon l'une quelconque des revendications 1 à 6, caractérisé en ce que la feuille est fragmentée (1,10-12) avant d'être appliquée, les fragments de la feuille étant aboutés en correspondance lors de leur application sur l'enveloppe, des parties des surfaces métalliques correspondantes des fragments étant galvaniquement reliées.

8. Ecran, notamment pour appareil d'imagerie par résonance magnétique nucléaire, caractérisé en ce qu'il comporte, une feuille (1) en un matériau diélectrique à faible perte et métallisée (2,3) sur ses deux faces (4,5), les surfaces métallisées de chaque face étant divisées (6,7) en des bandes métallisées disjointes et parallèles, chaque bande d'une face se trouvant à l'aplomb d'une séparation (8) de bandes de l'autre face, la feuille étant appliquée (14-16) contre une enveloppe cylindrique, et ses bords (17,19) parallèles aux bandes étant aboutés chant contre chant, et des surfaces métallisées bordant ces abouts sur au moins une face étant reliées galvaniquement (20-23) entre elles le long de l'aboutement.

9. Ecran selon la revendication 8, caractérisé en ce que l'application est faite avec de la colle.

10. Ecran selon la revendication 8, caractérisé en ce que l'application est faite par vissage, des métallisations (14) résidant aux emplacements réservés aux appuis (15) des vis (16) étant dégagées.

11. Ecran selon l'une quelconque des revendications 8 à 10, caractérisé en ce que la liaison galvanique comporte un feuillard (21) allongé, soudé de part et d'autre par ses bords aux surfaces (18,20) métallisées des abouts.

12. Ecran selon l'une quelconque des revendications 8 à 11, caractérisé en ce que la liaison galvanique est faite sur la surface (5) opposée à la surface (4) appliquée contre l'enveloppe.

13. Ecran selon l'une quelconque des revendications 8 à 12, caractérisé en ce que le matériau diélectrique est un polyimide.

14. Ecran selon l'une quelconque des revendications 8 à 12, caractérisé en ce que le matériau diélectrique est un polyéthylène.

15. Ecran selon l'une quelconque des revendications 8 à 14, caractérisé en ce que la feuille comporte plusieurs fragments (1,10-12) aboutés chant contre chant par leurs bords.

Fig.1

Fig.2

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl.4) |
|---|---|---|---|
| A | EP-A-0 073 375 (SIEMENS AG) <br> * Page 4, ligne 1 - page 5, ligne 9; page 6, ligne 16 - page 7, ligne 30 * | 1,8 | G 01 N 24/04 |
| | --- | | |
| A | EP-A-0 105 550 (N.V. PHILIPS' GLOEILAMPENFABRIEKEN) <br> * Page 2, ligne 20 - page 3, ligne 6; page 6, lignes 17-33 * | 1,8 | |
| | --- | | |
| A | EP-A-0 084 946 (TECHNICARE CORP.) <br> * Page 15, ligne 27 - page 16, ligne 12 * | 1,8 | |
| | --- | | |
| A | GB-A-2 034 123 (J. McDONALD) <br> * Page 1, lignes 36-51; page 3, lignes 38-72 * | 1,8 | |
| | --- | | DOMAINES TECHNIQUES RECHERCHES (Int. Cl.4) |
| A | US-A-4 514 586 (J. WAGGONER) <br> * Colonne 3, ligne 6 - colonne 4, ligne 66 * | 1 | G 01 N 24/00 <br> H 05 K 9/00 <br> H 01 F 27/00 |
| | ----- | | |

Le présent rapport de recherche a été établi pour toutes les revendications

| Lieu de la recherche <br> LA HAYE | Date d'achèvement de la recherche <br> 12-09-1986 | Examinateur <br> DIOT P.M.L. |
|---|---|---|